# EUROPEAN PATENT SPECIFICATION

(11) **EP 2 130 932 B1**
(45) Date of publication and mention of the grant of the patent: **11.09.2013**
(21) Application number: 08761434.3
(22) Date of filing: 14.03.2008
(51) Int. Cl.: C22C 1/10, H01L 23/373, C04B 41/51, C22C 1/05, C22C 5/00, C22C 9/00, C22C 21/00, C22C 26/00, C22C 29/06, C22C 29/16, C22C 47/08, C22C 32/00

(54) **THREE PHASE COMPOSITE MATERIAL WITH HIGH THERMAL CONDUCTIVITY AND ITS PRODUCTION**
DREIPHASIGER VERBUNDWERKSTOFF MIT HOHER WÄRMELEITFÄHIGKEIT UND SEINE HERSTELLUNG
MATÉRIAU COMPOSÉ TRIPHASÉ À HAUTE CONDUCTIVITÉ THERMIQUE ET SON PRODUCTION

(30) Priority: 27.03.2007 ES 200700804
(43) Date of publication of application: 09.12.2009
(73) Proprietor: UNIVERSIDAD DE ALICANTE, 03690 San Vicente del Raspeig (ES)
(72) Inventor: NARCISO ROMERO, Francisco, Javier, E-03690 San Vicente del Raspeig Alicante (ES); PRIETO ALFONZO, Richard, E-03690 San Vicente del Raspeig Alicante (ES); LOUIS CERECEDA, Enrique, E-03690 San Vicente del Raspeig Alicante (ES); MOLINA JORDA, José, Miguel, E-03690 San Vicente del Raspeig Alicante (ES)
(74) Representative: Carpintero Lopez, Francisco
(86) International application number: PCT/ES2008/000146
(87) International publication number: WO 2008/116947

(56) References cited:
- EP-A1- 0 370 546
- EP-A1- 0 765 946
- EP-A1- 1 160 860
- EP-A1- 1 477 467
- EP-A2- 1 168 438
- US-A- 5 228 494
- US-A- 5 834 115
- US-A1- 2006 169 434
- US-A1- 2006 182 990
- RODRIGUEZ-GUERRERO A ET AL: "Pressure infiltration of Al-12wt.% Si-X (X=Cu, Ti, Mg) alloys into graphite particle preforms", ACTA MATERIALIA, ELSEVIER, OXFORD, GB, vol. 54, no. 7, 1 April 2006 (2006-04-01), pages 1821-1831, XP027509493, ISSN: 1359-6454, DOI: DOI:10.1016/J.ACTAMAT.2005.11.041 [retrieved on 2006-03-14]
- MOLINA J.M. ET AL.: 'Infiltration of graphite preforms with Al-Si eutectic alloy and mercury' SCRIPTA MATERIALIA vol. 56, 21 March 2007, pages 991 - 994, XP022024010

## Description

The present invention is related to materials with high thermal conductivity for use as heat dissipaters in microelectronic and optoelectronic equipment and power generators.

### STATE OF THE ART

As dissipation of heat in the new generation of microelectronic and optoelectronic devices and in power electronics is a very important problem to be resolved by the electronics industries, great efforts are being made to develop new materials with high thermal performance that might offer solutions to this problem. The different thermal transport mechanisms acting in microelectronic and optoelectronic devices and systems and in power generators increase the complexity of the problem still further. There have been many solutions adopted to reduce excessive heat in these devices, some of which are described below.

One of the questions that is currently receiving special attention is the optimisation of the materials used in packaging systems in microelectronic and optoelectronic devices and power generators as it is necessary to eliminate heat in the various components of their structure: semiconductor, ceramic substrates, metal connections, polymers and materials used in soldered connections. One of the techniques used to maintain the temperature of devices within acceptable limits is the use of heat dissipaters.

In general, a heat dissipater is a device, manufactured with materials of high thermal conductivity, that is able to extract the heat generated by another object with which it is in thermal contact (or direct contact). Metals are the materials that are preferentially used for this end and among the most frequently used are Al and Cu. These materials, although they have high values of thermal conductivity (hereinafter abbreviated as TC) of 235 and 398 Wm⁻¹K⁻¹ respectively, also have high Coefficient of Thermal Expansion (hereinafter abbreviated as CTE) values of 23 and 17 x 10⁻⁶ K⁻¹, respectively.

Due to this latter property, a problem of incompatibility arises at high temperatures between the thermal expansion of metals used as dissipaters and that shown by microelectronic devices, especially semiconductors and ceramic substrates, which have relatively low CTE values. For example, the CTE of silicon Si and gallium arsenide GaAs are 4.2 and 6.5x10⁻⁶ K⁻¹, respectively. Similarly, although the CTE of ceramic substrates that act as electrical insulators (Al₂O₃, AIN, SiC, diamond) are similar to those of the semiconductors, in many cases their TC values do not satisfy the requirements for adequate heat dissipation.

Also, although artificial diamond, which has excellent properties, has been used with some success, the excessive production costs (the impossibility of cutting and machining being one of its main limitations) make it non-viable in low cost components.

The differences in expansion of various components can be partially compensated using alloys of low melting points in the interface between the semiconductor device and the heat dissipater. However, their use is limited by their low elastic limit as thermal changes that occur during the functioning of the devices may induce thermal creep. The materials typically used for this end are alloys of Sn-Pb, etc.

Among the solutions adopted to resolve the problem of marked differences in thermal expansion in packaging architecture, it is interesting to mention the use of metal-metal composite materials with low CTE (e.g. Cu/W or Cu/Mo). However, the dissipaters manufactured with these materials have a TC similar to that of aluminium, which is excessively low.

With the purpose of satisfying the needs for thermal dissipation, in recent years a series of high performance composite materials have been developed, amongst which is Al/SiC, which has been broadly used in the industry and which has a thermal conductivity around 180 to 240 W/mK and with CTE of 7 to 9x10⁻⁶K⁻¹.

Currently, composite materials can be found on the market that are based on diamond, whose properties are much better than those mentioned above, as their TC easily exceeds 500 W/mK and their CTE varies in the range of 5 to 7x10⁻⁶ K⁻¹. The process of manufacture, described in Japanese patents 11-67991 and 10-223812, consists in making a porous preform of diamond, followed by a modification of the surface by covering it with an agent with good adherence to metal such as, for example, TiC. Subsequently, the porous preform is infiltrated with a metal alloy based on Ag or Cu. The main problem with these composite materials is their excessive production costs, the raw materials and the mechanisation costs being mainly responsible for their high prices.

The document Rodriguez-Guerrero et al. Acta Materialia 54 (2006), 1821-1831 investigates the pressure infiltration of Al and Al-12wt% Si alloys into performs of packed graphite particles. More in particular, it discloses a composite material that can be produced by: (a) coating graphite particles with K₃ZrF₆ (that includes mixing graphite particles and K₃ZrF₆ particles, adding the mixture to an ethanol solution for forming a slurry and drying this slurry; (b) packing the particle mixture by alternating vibrations and strokes with no pressure applied to obtain a preform; and (c) infiltrating this perform with Al-12wt% Si alloy.

The patent EP 1477467 discloses a composite material that is produced by (1) graphitizing an extrudate of carbon particles and/or carbon fibers and tar pitch by burning; (2) impregnating the resultant porous graphitized extrudate with a molten metal (Cu, Al, Ag, among many others, and alloys of them) at high temperature and pressure; and (3) heat-treating the resultant graphite/metal composite material.

The document EP1160860 discloses a composite material that is obtained by a method of producing a porous sintered member and infiltrating it with a molten metal (first, second and fifth production methods), as well as by another methods based on the use of the metal in the form of powder (third and fourth production methods).

The Document US 2006/0169434 and document US 2006/0182990 disclose an aluminum composite material having improved mechanical properties. This composite is manufactured by impregnating a perform with an aluminum alloy. This perform is formed by (1) mixing an alumina fiber and graphite or activated charcoal and an inorganic binder (alumina sol) in water; (2) removing water; and (3) sintering the resultant mixed product at 1000 °C.

A possible solution to this problem can be found in the European patent application EP 1168438 A2 where diamond is replaced by pyrolytic graphite. Unfortunately, although the machining costs can be reduced with these materials, the type of graphite used causes the production costs to continue to be high.

### DESCRIPTION OF THE INVENTION

The present invention's fundamental object is the development of a composite material as defined by claim 1 with high thermal performance and low production cost to be used in semiconductor devices as a heat dissipater and a process for producing this material. Specifically, the materials that are the object of this invention have a thermal conductivity higher than 200 Wm⁻¹K⁻¹ and a coefficient of thermal expansion in the range of 2 to 10x10⁻⁶K⁻¹ (measured in the temperature range of 20 to 300°C in at least two directions).

The composite material of claim 1 is composed of three phases: 1) between 10 and 80% (v/v) of a phase consisting mainly of graphite flakes (phase A); 2) between 15 and 70% (v/v) of a second phase (phase B) being particles or fibers of a flake separating material, selected from a ceramic material (which is selected from SiC, BN, AlN, TiB₂ and diamond) and carbon fibers, of high thermal performance in at least one direction; and finally, 3) a third phase (phase C) consisting of a metal alloy, composed of an alloy where the major component consisting of a metal selected from the group consisting of aluminium, silver and copper; alloying with at least one of the following elements: Si, Cr, Ti, V and B, together with the inevitable impurities. Phases A and B are mixed, forming a preform in which the strongly orientated compact layers of phase A are alternated with the more diluted layers of phase B, enabling in this way the infiltration of the alloy (phase C).

Both the materials used and the manufacturing process chosen in this present invention enable keeping the production costs down to reasonable levels, achieving competitive thermal properties at the same time.

Although the three phases must have good thermal properties, it is phase A (graphite flakes) that is the principally responsible for the properties of the material that is the object of this invention. Phase B acts as a separator of the layers of phase A, enabling the infiltration of phase C, which consolidates the preform.

The component of phase B is selected from the group consisting of SiC, BN, AIN, TiB₂, diamond and carbon fibers. In the context of the present invention, carbon fibers of high thermal performance are those with thermal conductivity above 200 W m⁻¹K⁻¹, more preferably above 400 W m⁻¹K⁻¹, and a coefficient of thermal expansion in the range of 2 to 10x10⁻⁶ K⁻¹ (measured in the temperature range of 20 to 300°C in at least one direction).

According to a preferred embodiment, phase C comprises a metal alloy, the main component of which is selected from Al, Ag and Cu, and alloying with at least one of the following elements (including the inevitable impurities): Si, Cr, Ti, V and B, preferably in amounts that can vary in the range of 0 to 15%. According to a more preferred embodiment, phase C comprises some alloy of the families Al-Si, Ag-Si or Cu-Cr, with the following being still more preferred: Al-12%Si, Ag-3%Si, Cu-0.1%Cr, Cu-0.3%Cr or Cu-1%Cr.

The graphite content of the composite material varies in the range 10 to 80% by volume, the ceramic material or carbon fibers varies in the range 15 to 70% by volume and finally, the infiltrated alloy content completes the remaining percentage.

In a preferred embodiment, the composite material of the invention comprises graphite flakes (phase A) in the range of 20 to 1000 µm in size, while phase B comprises carbon fibers in the range of 5 to 10 µm in diameter and in the range of 100 to 300 µm in length, or alternatively, ceramic particles in the range of 6 to 200 µm in size.

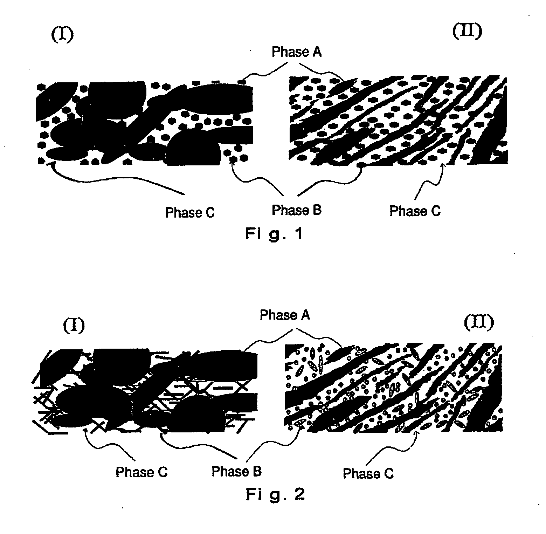

Based on the description above, and as shown in Figures 1 and 2, according to a preferred embodiment of the present invention the composite material of high thermal conductivity proposed in this invention comprises a first phase of graphite particles in the form of flakes (phase A), a second material of ceramic particles in the range of 6 to 200 µm in size or in the range of 6 to 170 µm (phase B) with high thermal conductivity values (e.g. SiC, BN, AIN, TiB₂, diamond, etc.) or carbon fibers of high thermal performance, and a third constituent (phase C) consisting of alloys of aluminium, silver or copper with a least one of the following elements: Si, Cr, Ti, V and B.

The preform is made by mixing the materials described as phases A and B, varying the content of phase B in the range 15 to 70% and either using or not using a non-polar organic solvent, for example hexane or cyclohexane. The mixture of the constituents, graphite flakes (phase A) and particles (phase B), preferably SiC, BN, diamond or carbon fibers, can be performed by any of the methods usually used by the industry, wet stirring, mechanical, magnetic stirring, etc. The excess non-polar solvent is removed and eliminated from the mixture by an appropriate technique that depends on the type of solvent used, various methods for the removal of solvents being known by an expert in the field.

The mixture of the components described as phase A and B in the various proportions established above is achieved in a resilient metal mould with the geometry desired. The plugs introduced into the mould cavity are lubricated in order to facilitate their removal. The mixtures are compacted under pressure, which is preferably 40 MPa or higher. The lower limit of pressure applied must be sufficiently high to guarantee the consolidation of the particles of the phases A and B, while the upper limit is reached when a substantial quantity of pores are closed, not allowing infiltration of the preform by the alloy. In this way, a porous preform is obtained with the distribution of the phases A and B that is desired. Once this has been compacted, it is removed from the mould.

The consolidated preform is placed into a temperature resistant mould (metal, ceramic, quartz, etc.). The process of infiltration is carried out by placing the preform on top of or under the infiltrating metal alloy. The metal alloy can be used in various ways: block, cylinder, scales, powder, etc. The alloy and the porous preform are kept separate during the heating and melting stage of the metal by means of a porous filter (for example aluminium paper). The quantity of alloy should be sufficient to fill all the pores of the preform in order to obtain a composite material with the minimum porosity possible.

The combination making up by phases A, B and C, as well as the metal mould containing them, is heated in a vacuum in order to prevent decomposition of phases with high carbon (graphite) content and to encourage the infiltration of phase C. The chamber may or may not be purged before the heating phase. Heating is carried out from ambient temperature to approximately 60 to 100°C above the alloy melting point. For example, the temperature used for infiltration in the case of Al-Si alloys is chosen in the range of 660 to 700°C and for Ag-Si alloys the temperature is in the range of 1000 to 1050°C.

Once the final infiltration temperature has been reached and after a period of time for temperature equalisation, pressure is applied, using a gas or other mechanical means as the compressing agent. The material obtained is solidified quickly, removing it from the heat source and taking it to a heat sink in order to obtain rapid and unidirectional cooling.

The composite material is produced in the forms and sizes that are most appropriate for its subsequent processing (cutting, machining, polishing, etc.) and use. It comprises layers of orientated graphite flakes alternating with layers of a composite material consisting of phases B and C. It is a light material, of high thermal conductivity and low coefficient of thermal expansion in at least two specified directions and which presents no problem for cutting, machining and polishing.

During the description and the claims, the words "comprising", "composed of" and their variants are not intended to exclude other technical characteristics, additives, components or steps. The content of the application, the priority of which is claimed, as well as the contents of the priority application summaries and the present application are incorporated here as a reference.

For an expert in the field, other objects, advantages and characteristics of the invention will emerge partly from the description and partly from the practice of the invention. The following examples and figures are provided for the purpose of illustration only and are not intended to be limiting of the present invention.

### BRIEF DESCRIPTION OF THE FIGURES

- Figure 1: Longitudinal (I) and transverse (II) views of the material described in the present invention composed of three phases:
Phase A: graphite flakes.
Phase B: a separating material in the form of particles, preferably a ceramic.
Phase C: a metal alloy.
- Figure 2: Longitudinal (I) and transverse (II) views of the material described in the present invention composed of three phases:
Phase A: graphite flakes.
Phase B: a separating material in the form of fibers, preferably carbon fibers.
Phase C: a metal alloy.

### DETAILED DESCRIPTION OF EXAMPLES OF EMBODIMENT

### Example 1

To manufacture this material, the following were used for phases A and B (see Fig. 1): graphite flakes of 400 µm in diameter and particles of SiC of an average of 13 µm in diameter respectively. The proportions of phases A and B were varied over the range of 30 to 55% and 61 to 33% by volume respectively. Phase C in this case was a eutectic alloy of Al-12%Si. The alloy was chosen to minimize the melting temperature and maximize the compatibility with the reinforcements. The volume fraction of phase C is equal to the part remaining of the sum of the volume fractions of phases A and B. A detailed description of the volume fractions in each phase used is shown in Table 1.

The material of the present example was manufactured according to the following stages:
a) Phases A and B were mixed in the wet with a non-polar solvent (hexane). The quantity of solvent must enable homogenous mixing of the phases A and B. The mixing process was performed using mechanical stirring. The mixture was filtered to remove the liquid phase and the remaining solvent was evaporated by heating to 90°C.
b) The mixture of phases A and B was consolidated under a pressure of 40 MPa in a metal mould sufficiently strong to withstand the compaction pressure. The pressure was applied by means of a previously lubricated piston. Using this procedure, a preferred orientation of the graphite flakes (phase A) was achieved.
c) The compacted preform was removed from the mould and placed in an infiltration chamber next to the alloy (phase C). The preform and the metal were separated by a porous filter during the heating stage, which was performed in a vacuum. The infiltration temperature depends on the chosen alloy; in this case it was 660°C.
d) The preform was infiltrated under pressure using a pressurised gas (nitrogen). The material obtained was rapidly solidified, taking it away from the heat source and moving it to a heat sink.

The composite material manufactured in this way was characterised in having orientated graphite flakes (phase A), alternating with layers of a composite material consisting of phases B and C. In Table 1 the values of TC and CTE for various samples obtained in this example, in the plane defined by the graphite flakes, are shown. The test samples used for the measurements of TC and CTE (of dimensions 50x10x10 mm and 8x4x4 mm respectively) were cut (machined and polished) from the samples manufactured according to the process described above, the dimensions of which were 52x11 x11 mm in this case.

**TABLE 1**

| Sample | Phase A Graphite flakes. (%) | Phase B SiC particles (%) | Phase C Al-12%Si alloy (%) | TC (W/mK) (in the plane) | CTE × 10⁻⁶ K⁻¹ (in the plane) |
|---|---|---|---|---|---|
| 1 | 55 | 33 | remainder | 415 | 7.8 |
| 2 | 45 | 48 | remainder | 342 | 9.4 |
| 3 | 43 | 52 | remainder | 326 | 8.4 |
| 4 | 30 | 61 | remainder | 322 | 7.8 |

| | | | | | |
|---|---|---|---|---|---|
| TC measured according to the ASTM E 1225 standard. CTE measured according to the ASTM E 831 standard. | | | | | |

### Example 2

To manufacture this material, the following were used for phases A and B (see Fig. 1): graphite flakes of 400 µm in diameter and particles of SiC of an average of 22 µm in diameter respectively. The proportions of phases A and B were varied over the range of 32 to 60% and 53 to 27% by volume respectively. Phase C in this case was a eutectic alloy of Al-12%Si. The alloy was chosen to minimize the melting temperature and maximize the compatibility with the reinforcements. The volume fraction of phase C is equal to the part remaining of the sum of the volume fractions of phases A and B. A detailed description of the volume fractions in each phase used is shown in Table 2.

The material of the present example was manufactured according to the processes described in stages a)-d) of Example 1: mixing, consolidation of the preform, melting of the metal stage, infiltration and finally solidification of the metal.

The composite material manufactured in this way was characterised in having graphite flakes (phase A), alternating with layers of a composite material consisting of phases B and C. In Table 2 the values of TC and CTE for various samples obtained in this example, in the plane defined by the graphite flakes, are shown. The test samples used for the measurements of TC and CTE (of dimensions 50x10x10 mm and 8x4x4 mm respectively) were cut (machined and polished) from the samples manufactured according to the process described above, the dimensions of which were 52x11 x11 mm in this case.

**TABLE 2**

| Sample | Phase A Graphite flakes. | Phase B SiC particles | Phase C Al-12%Si alloy | TC (W/mK) (in the plane) | CTE × 10⁻⁶ K⁻¹ (in the plane) |
|---|---|---|---|---|---|
| | (%) | (%) | (%) | | |
| 1 | 60 | 27 | remainder | 390 | 6.0 |
| 2 | 53 | 35 | remainder | 368 | 7.0 |
| 3 | 32 | 48 | remainder | 323 | 9.0 |
| 4 | 32 | 53 | remainder | 294 | 9.6 |

| | | | | | |
|---|---|---|---|---|---|
| TC measured according to the ASTM E 1225 standard. CTE measured according to the ASTM E 831 standard. | | | | | |

### Example 3

To manufacture the material of this example, the following were used for phases A and B (see Fig. 1): graphite flakes of 400 µm in diameter and particles of SiC in the range of 6 to 170 µm in diameter respectively. The proportions of phases A and B were varied over the range of 42 to 77% and 44 to 18% by volume respectively. Phase C in this case was a eutectic alloy of Al-12%Si. The alloy was chosen to minimize the melting temperature and maximize the compatibility with the reinforcements. The volume fraction of phase C is equal to the part remaining of the sum of the volume fractions of phases A and B. A detailed description of the volume fractions in each phase used is shown in Table 3.

The material of the present example was manufactured according to the processes described in stages a)-d) of Example 1: mixing, consolidation of the preform, melting of the metal stage, infiltration and finally solidification of the metal.

The composite material manufactured in this way was characterised in having graphite flakes (phase A), alternating with layers of a composite material consisting of phases B and C. In Table 3 the values of TC and CTE for various samples obtained in this example, in the plane defined by the graphite flakes, are shown. The test samples used for the measurements of TC and CTE (of dimensions 50x10x10 mm and 8x4x4 mm respectively) were cut (machined and polished) from the samples manufactured according to the process described above, the dimensions of which were 52x11 x11 mm in this case.

**TABLE 3**

| Sample | Phase A Graphite flakes. | Phase B SiC particles | Phase C Al-12%Si alloy | Particle size (µm) Phase B | TC (W/mK) (in the plane) | CTE × 10⁻⁶ K⁻¹ (in the plane) |
|---|---|---|---|---|---|---|
| | (%) | (%) | (%) | | | |
| 1 | 46 | 44 | remainder | 6 | 342 | 7.7 |
| 2 | 42 | 42 | remainder | 8 | 399 | 7.8 |
| 3 | 55 | 33 | remainder | 12 | 415 | 7.8 |
| 4 | 53 | 35 | remainder | 25 | 368 | 7.0 |
| 5 | 48 | 44 | remainder | 40 | 400 | 6.5 |
| 6 | 77 | 18 | remainder | 170 | 437 | 5.8 |

| | | | | | | |
|---|---|---|---|---|---|---|
| TC measured according to the ASTM E 1225 standard. CTE measured according to the ASTM E 831 standard. | | | | | | |

### Example 4

To manufacture the material of this example, the following were used for phases A and B (see Fig. 1): graphite flakes of 400 µm in diameter and particles of SiC of an average of 13 µm in diameter. The proportions of phases A and B were varied over the range of 32 to 56% and 49 to 24% by volume respectively. Phase C in this case was a eutectic alloy of Ag-3%Si. The alloy was chosen to minimize the melting temperature and maximize the compatibility with the reinforcements. The volume fraction of phase C is equal to the part remaining of the sum of the volume fractions of phases A and B. A detailed description of the volume fractions in each phase used is shown in Table 4.

The material of the present example was manufactured according to the processes described in stages a)-d) of Example 1: mixing, consolidation of the preform, melting of the metal stage, infiltration and finally solidification of the metal. There were two differences with respect to the process in Example 1: i) the mixing of the phases A and B were performed using cyclohexane as the solvent in place of hexane, and ii) the melting of phase C was carried out at 1000°C.

The composite material manufactured in this way was characterised in having orientated graphite flakes (phase A), alternating with layers of a composite material consisting ofphases B and C. In Table 4 the values of TC and CTE for various samples obtained in this example, in the plane defined by the graphite flakes, are shown. The test samples used for the measurements of TC and CTE (of dimensions 50x10x10 mm and 8x4x4 mm respectively) were cut (machined and polished) from the samples manufactured according to the process described above, the dimensions of which were 52x11x11 mm in this case.

**TABLE 4**

| Sample | Phase A Graphite flakes. (%) | Phase B SiC particles (%) | Phase C Ag-3%Si (%) | TC (W/mK) (in the plane) | CTE × 10⁻⁶K⁻¹ (in the plane) |
|---|---|---|---|---|---|
| 1 | 56 | 24 | remainder | 413 | 7.3 |
| 2 | 53 | 31 | remainder | 360 | 8.2 |
| 3 | 32 | 49 | remainder | 302 | 8.6 |

| | | | | | |
|---|---|---|---|---|---|
| TC measured according to the ASTM E 1225 standard. CTE measured according to the ASTM E 831 standard. | | | | | |

### Example 5. The example 5 does not belong to the invention

To manufacture this material, the following were used for phases A and B (see Fig. 1): graphite flakes of 400 µm in diameter and high thermal performance carbon fibers of 100 to 300 µm in average length and of 5 to 10 µm in average diameter. The contents of phases A and B were fixed at 75% and 10% by volume respectively. As phase C, the eutectic alloys Al-12%Si and Ag-3%Si and the alloys Cu-x%Cr (x=0.0, 0.1, 0.3 and 1.0) were selected. The alloy was chosen to minimize the melting temperature and maximize the compatibility with the reinforcements. The volume fraction of phase C is equal to the part remaining of the sum of the volume fractions of phases A and B. A detailed description of the volume fractions in each phase used is shown in Table 5.

The material of the present example was manufactured according to the processes described in stages a)-d) of Example 1: mixing, consolidation of the preform, melting of the metal stage, infiltration and finally solidification of the metal. In this case, the selected melting temperatures were: 660°C for the alloy Al-12%Si, 1000°C for Ag-3%Si, and 1200°C for the alloys Cu-x%Cr.

The composite material manufactured in this way was characterised in having orientated graphite flakes (phase A), alternating with layers of a composite material consisting of phases B and C. In Table 5 the values of TC and CTE for various samples obtained in this example, in the plane defined by the graphite flakes, are shown. The test samples used for the measurements of TC and CTE (of dimensions 50x10x10 mm and 8x4x4 mm respectively) were cut (machined and polished) from the samples manufactured according to the process described above, the dimensions of which were 52x11 x11 mm in this case.

**TABLE 5**

| Sample | Phase A Graphite flakes (%) | Phase B Carbon fiber (%) | Phase C Alloy (%) | Phase C Alloy | TC (W/mK) (in the plane) | CTE × 10⁻⁶ K⁻¹ (in the plane) |
|---|---|---|---|---|---|---|
| 1 | 75 | 10 | remainder | Al-12%Si | 367 | 3.0 |
| 2 | 75 | 10 | remainder | Cu | 403 | 2.5 |
| 3 | 75 | 10 | remainder | Cu-0.1%Cr | 231 | 3.0 |
| 4 | 75 | 10 | remainder | Cu-0.3%Cr | 457 | 3.0 |
| 5 | 75 | 10 | remainder | Cu-1%Cr | 298 | 2.0 |
| 6 | 75 | 10 | remainder | Ag-3%Si | 548 | 3.0 |

| | | | | | | |
|---|---|---|---|---|---|---|
| TC measured according to the ASTM E 1225 standard. CTE measured according to the ASTM E 831 standard. | | | | | | |

### Example 6

To manufacture this material, the following were used for phases A and B (see Fig. 1): graphite flakes of 400 µm in diameter and particles of diamond of 100 µm in diameter. The proportions of phases A and B were fixed at 60% and 20% by volume respectively. As phase C, the eutectic alloys Al-12%Si and Ag-3%Si were selected. The alloy was chosen to minimize the melting temperature and maximize the compatibility with the reinforcements. The volume fraction of phase C is equal to the part remaining of the sum of the volume fractions of phases A and B. A detailed description of the volume fractions in each phase used is shown in Table 6.

The material of the present example was manufactured according to the processes described in stages a)-d) of Example 1: mixing, consolidation of the preform, melting of the metal stage, infiltration and finally solidification of the metal. In this case, the selected melting temperatures were: 660°C for the alloy Al-12%Si, 1000°C for Ag-3%Si.

The composite material manufactured in this way was characterised in having orientated graphite flakes (phase A), alternating with layers of a composite material consisting of phases B and C. In Table 6 the values of TC and CTE for various samples obtained in this example, in the plane defined by the graphite flakes, are shown. The test samples used for the measurements of TC and CTE (of dimensions 50x10x10 mm and 8x4x4 mm respectively) were cut (machined and polished) from the samples manufactured according to the process described above, the dimensions of which were 52x11 x11 mm in this case.

**TABLE 6**

| Sample | Phase A Graphite flakes (%) | Phase B diamond particles (%) | Phase C alloy (%) | Phase C alloy | TC (W/mK) (in the plane) | CTE × 10⁻⁶ K⁻¹ (in the plane) |
|---|---|---|---|---|---|---|
| 1 | 60 | 20 | remainder | Al-12%Si | 451 | 4.4 |
| 2 | 60 | 20 | remainder | Ag-3%Si | 253 | 6.4 |

| | | | | | | |
|---|---|---|---|---|---|---|
| TC measured according to the ASTM E 1225 standard. CTE measured according to the ASTM E 831 standard. | | | | | | |

## Claims

1. Composite material **characterised in that** it consists of three phases:
i)) between 10 and 80% (v/v) of Phase A: graphite particles in the form of flakes;
ii)) between 15 and 70% (v/v) of Phase B: particles or fibers of a flake separating material selected from the group consisting of SiC, BN, AIN, TiB₂, diamond and carbon fibers;
iii) the remainder of Phase C: metal alloy, composed of an alloy where the major component consisting of a metal selected from the group consisting of aluminium, silver and copper; alloying with al least one of the following elements: Si, Cr, Ti, V and B, together with the inevitable impurities.

2. The composite material according to claim 1, **characterised in that** phase A and phase B are intimately mixed forming a compact preform into which phase C is infiltrated.

3. The composite material according to any of the previous claims 1 to 2, **characterised in that** phase C comprises an alloy Al-Si, Ag-Si or Cu-Cr.

4. The composite material according to any of the previous claims 1 to 3, **characterised in that**:
i) the graphite flakes are between 20 and 1000 µm in size;
ii) phase B comprises carbon fibers of an average of 5 to 10 µm in diameter and an average of 100 to 300 µm in length, or, alternatively, particles of ceramic of average diameter in the range of 6 to 200 µm.

5. The composite material according to any of the previous claims 1 to 4, **characterised in that** it has layers of orientated graphite flakes (phase A) alternating with layers of a composite material consisting of phases B and C.

6. A process for the manufacture of a composite material according to claims 1 to 5, **characterised in that** in comprises the following stages:
a) mixing the graphite flakes with particles of ceramic material or alternatively carbon fibers;
b) moulding, by means of pressure, the mixture of stage a) as a porous preform;
c) placing the porous preform obtained in stage b) next to the metal for performing the infiltration of the alloy;
d) heating the assembly until a temperature slightly higher than the melting point of the alloy has been reached and the application of pressure to force the alloy to infiltrate the pores of the preform.

7. Use of the composite material according to claims 1 to 5 as a contact heat dissipater in microelectronic, optoelectronic devices and power generators.

## Patentansprüche

1. Verbundmaterial, **dadurch gekennzeichnet, dass** das Verbundmaterial aus drei Phasen besteht:
i) zwischen 10 und 80 Vol.-% einer Phase A: Graphitpartikel in der Form von Flocken;
ii) zwischen 15 und 70 Vol.-% einer Phase B: Partikel oder Fasern eines flockenförmigen Trennmaterials, das aus SiC, BN, AIN, TiB₂, Diamant und Kohlenstofffasern ausgewählt ist; und
iii) einem Rest aus einer Phase C: eine Metalllegierung, die aus einer Legierung aus einer Hauptkomponente aus einem Material, das aus Aluminium, Silber und Kupfer ausgewählt wird, und mindestens einem der folgenden Elemente: Si, Cr, Ti, V und B, und unvermeidbaren Verunreinigungen besteht.

2. Verbundmaterial nach Anspruch 1, **dadurch gekennzeichnet, dass** die Phase A und die Phase B innig vermischt sind, um eine kompakte Vorform zu erhalten, in die die Phase C infiltriert ist.

3. Verbundmaterial nach Anspruch 1 oder 2, **dadurch gekennzeichnet, dass** die Phase C eine Al-Si-, Ag-Si- oder Cu-Cr-Legierung aufweist.

4. Verbundmaterial nach einem der vorangehenden Ansprüche, **dadurch gekennzeichnet, dass**:
i) die Graphitflocken eine Größe zwischen 20 und 1000 µm haben;
ii) die Phase B Kohlenstofffasern mit einem mittleren Durchmesser von 5 bis 10 µm und einer mittleren Länge von 100 bis 300 µm oder alternativ Keramikpartikel mit einem mittleren Durchmesser im Bereich von 6 bis 200 µm aufweist.

5. Verbundmaterial nach einem der vorangehenden Ansprüche, **dadurch gekennzeichnet, dass** das Verbundmaterial Lagen aus orientierten Graphitflocken (Phase A) aufweist, die alternierend mit Lagen aus einem Verbundmaterial angeordnet sind, das aus den Phasen B und C besteht.

6. Verfahren zum Herstellen eines Verbundmaterials nach einem der Ansprüche 1 bis 5, **dadurch gekennzeichnet, dass** das Verfahren die folgenden Schritte aufweist:
a) Mischen der Graphitflocken mit Keramikmaterialpartikeln oder alternativ mit Kohlenstofffasern;
b) Gießen der Mischung von Schritt a) unter Druck als eine poröse Vorform;
c) Anordnen der in Schritt b) erhaltenen porösen Vorform in der Nähe des Metalls, um die Infiltration der Legierung auszuführen; und
d) Erwärmen der Zusammenstellung, bis eine Temperatur erreicht worden ist, die etwas höher ist als der Schmelzpunkt der Legierung, und Ausüben eines Drucks, um zu veranlassen, dass die Legierung zwangsweise in die Poren der Vorform infiltriert wird.

7. Verwendung des Verbundmaterials nach einem der Ansprüche 1 bis 5 als ein Kontakt-Wärmeableitkörper in mikroelektronischen und optoelektronischen Geräten und in Stromaggregaten.

## Revendications

1. Matériau composite **caractérisé en ce qu'**il est constitué de trois phases:
i) entre 10 et 80 % (v/v) de Phase A : des particules de graphite sous la forme de flocons ;
ii) entre 15 et 70 % (v/v) de Phase B : des particules ou fibres d'un matériau de séparation de flocons choisies dans le groupe constitué de SiC, BN, AIN, TiB₂, diamant et fibres de carbone ;
iii) le reste de Phase C : alliage de métal, composé d'un alliage où le composant majeur consiste en un métal choisi dans le groupe constitué d'aluminium, d'argent et de cuivre ; s'alliant à au moins l'un des éléments suivants : Si, Cr, Ti, V et B, conjointement avec les impuretés inévitables.

2. Matériau composite selon la revendication 1, **caractérisé en ce que** la Phase A et la Phase B sont intimement mélangées, formant une préforme compacte dans laquelle la Phase C est infiltrée.

3. Matériau composite selon l'une quelconque des revendications précédentes 1 à 2, **caractérisé en ce que** la Phase C comprend un alliage Al-Si, Ag-Si, ou Cu-Cr.

4. Matériau composite selon l'une quelconque des revendications précédentes 1 à 3, **caractérisé en ce que** :
i) les flocons de graphite ont une taille comprise entre 20 et 1 000 µm ;
ii) la Phase B comprend des fibres de carbone d'un diamètre moyen de 5 à 10 µm et d'une longueur moyenne de 100 à 300 µm, ou, en variante, des particules de céramique de diamètre moyen de la plage de 6 à 200 µm.

5. Matériau composite selon l'une quelconque des revendications précédentes 1 à 4, **caractérisé en ce qu'**il comporte des couches de flocons de graphite orientées (Phase A) alternant avec des couches d'un matériau composite constituées des Phases B et C.

6. Procédé de fabrication d'un matériau composite selon les revendications 1 à 5, **caractérisé en ce qu'**il comprend les étapes suivantes consistant à :
a) mélanger les flocons de graphite avec des particules de matériau céramique ou en variante des fibres de carbone ;
b) mouler, par pression, le mélange de l'étape a) en tant que préforme poreuse ;
c) placer la préforme poreuse obtenue à l'étape b) près du métal pour réaliser l'infiltration de l'alliage ;
d) chauffer l'ensemble jusqu'à atteindre une température légèrement plus élevée que le point de fusion de l'alliage et appliquer une pression pour forcer l'alliage à s'infiltrer dans les pores de la préforme.

7. Utilisation du matériau composite selon la revendication 1 à 5 en tant que dissipateur de chaleur de contact dans des dispositifs microélectroniques, optoélectroniques et des générateurs d'électricité.
